# EUROPÄISCHE PATENTSCHRIFT

(11) **EP 2 681 773 B1**
(45) Veröffentlichungstag und Bekanntmachung des Hinweises auf die Patenterteilung: **14.10.2015**
(21) Anmeldenummer: 12707035.7
(22) Anmeldetag: 23.02.2012
(51) Int. Cl.: H01L 31/048, H01L 31/02

(54) **PHOTOVOLTAISCHES MODUL UND VERFAHREN ZU DESSEN HERSTELLUNG**
PHOTOVOLTAIC MODULE AND METHOD FOR PRODUCING SAME
MODULE PHOTOVOLTAÏQUE ET PROCÉDÉ DE FABRICATION DUDIT MODULE PHOTOVOLTAÏQUE

(30) Priorität: 28.02.2011 DE 102011012582
(43) Veröffentlichungstag der Anmeldung: 08.01.2014
(73) Patentinhaber: Fraunhofer-Gesellschaft zur Förderung der angewandten Forschung e.V., 80686 München (DE)
(72) Erfinder: WIRTH, Harry, 79249 Merzhausen (DE)
(74) Vertreter: Pfenning, Meinig & Partner GbR
(86) Internationale Anmeldenummer: PCT/EP2012/000798
(87) Internationale Veröffentlichungsnummer: WO 2012/116796

(56) Entgegenhaltungen:
- DE-A1-102009 009 036
- JP-A- 2002 118 279

## Beschreibung

Die Erfindung betrifft ein photovoltaisches Modul aus mindestens einer Solarzelle und einer Trägerstruktur, wobei die Solarzelle von der Trägerstruktur durch einen Luftspalt beabstandet ist und wobei an einzelnen Punkten stoffschlüssige Verbindungen zwischen Solarzelle und Trägerstruktur nur vereinzelt existieren. Hierdurch werden photovoltaische Module bereitgestellt, bei denen die Menge an Kontaktmaterial für die stoffschlüssige Verbindung deutlich reduziert werden kann.

Für den Aufbau von Solarmodulen müssen Solarzellen auf einer Trägerstruktur fixiert werden. Diese Trägerstruktur führt zu einer Stabilisierung der einzelnen Zellen sowie die gegenseitige Lage der Zellen und schützt die Zellen vor kritischen mechanischen Belastungen und ggf. auch vor Diffusion von korrosiven Stoffen wie Wasser oder Sauerstoff. Ebenso ermöglicht die Trägerstruktur ggf. eine elektrische Isolation.

In der Regel werden als Trägerstrukturen frontseitige Glasscheiben eingesetzt. Ebenso ist es aber auch möglich, dass eine rückseitige Trägerstruktur eingesetzt wird, wie z.B. ein Blech, das Wärme von der Solarzelle an ein rückseitiges Medium durchleiten kann, zur solarthermischen Nutzung.

Da Solarzellen im Betrieb erhebliche Mengen an Wärme abführen müssen, ist ein guter Warmeübergang zwischen den Solarzellen und der Trägerstruktur vorteilhaft. Die elektrische Leistung der Solarzellen hat einen negativen Temperaturkoeffizienten, zudem belasten hohe Temperaturen die eingesetzten Materialien des photovoltaischen Moduls. Besonders hohe Anforderungen hinsichtlich der Temperaturen bzw. der Wärmeabgabe existieren bei kombinierten solarthermischen Anwendungen sowie bei Konzentratoranwendungen.

Das Problem von linearen Wärmeausdehnungsdifferenzen zwischen der Solarzelle, die auf Basis von Silizium oder Kupfer konzipiert sein kann, und der Trägerstruktur, die aus Glas, Aluminium oder Kupfer gefertigt sein kann, muss gelöst werden, da ansonsten thermo-mechanische Spannungen zu einem Materialversagen führen können. Je näher dabei die Solarzellen an der Trägerstruktur liegen, was einen verbesserten Wärmeübergang ermöglicht, desto schwieriger fällt in diesem System der Ausgleich der Wärmeausdehnungsdifferenzen.

Im Stand der Technik werden Solarzellen in der Regel auf eine Glasscheibe auflaminiert, wobei ein Einkapselungsmaterial mit einer typischen Schichtdicke um 500 µm verwendet wird. Auf der Rückseite wird mit Hilfe des gleichen Einkapselungsmaterials eine Rückseitenfolie aufgebracht. Derartige System sind aus der WO 00/46860 und der EP 1 030 376 bekannt. Eine Reduzierung der Schichtdicke des Einkapselungsmaterials ist bei derartigen Systemen aufgrund der thermo-mechanischen Spannungen nicht möglich. Ein wesentlicher Nachteil derartiger Systeme ist somit der hohe Materialverbrauch an Einkapselungsmaterial pro Fläche. Bei Anwendung von Solarzellen auf thermischen Kollektoren muss die Schichtdicke wegen der deutlich höheren maximalen Temperatur von mindestens 150 °C sogar noch vergrößert werden. Im Stand der Technik wird als gängiges Einkapselungsmaterial EthylenVinylacetat verwendet, das eine Wärmeleitfähigkeit von etwa 0,2 bis 0,3 W/(nK) aufweist. Hieraus folgt ein Wärmedurchgangskoeffizient um 500 W/(m²K) zwischen den Solarzellen und der Trägerstruktur. Für einen Wärmestrom von 750 W/m² ist somit eine Temperaturdifferenz von 1,5 °C notwendig. Bei doppelter Schichtdicke erhöht sich diese auf 3 °C.

JP 2002 118279 offenbart ein photovoltaisches Modul, wobei die Solarzelle von der Trägenstruktur durch einen Luftspalt beabstandet ist.

Ausgehend hiervon war es Aufgabe der vorliegenden Erfindung, ein photovoltaisches Modul bereitzustellen, bei dem die Menge an zu verwendendem Einkapselungsmaterial drastisch reduziert werden kann, wobei gleichzeitig ein verbesserter Schutz vor thermo-mechanischen Spannungen und ein verbesserter Wärmeübergang gewährleistet ist.

Diese Aufgabe wird durch das photovoltaische Modul mit den Merkmalen des Anspruchs 1 und das Verfahren zu dessen Herstellung mit den Merkmalen des Anspruchs 12 gelöst. Die weiteren abhängigen Ansprüche zeigen vorteilhafte Weiterbildungen auf.

Erfindungsgemäß wird ein photovoltaisches (PV) Modul aus mindestens einer Solarzelle und einer Trägerstruktur bereitgestellt, wobei die Solarzelle von der Trägerstruktur durch einen Luftspalt beabstandet ist oder die Solarzelle bereichsweise auf der Trägerstruktur aufliegt und die mindestens eine Trägerstruktur mindestens eine lokal begrenzte Vertiefung aufweist. In dieser Vertiefung ist eine elastische, stoffschlüssige Verbindung aus einem Kontaktmaterial zwischen Solarzelle und Trägerstruktur angeordnet.

Die erfindungsgemäße Lösung sieht somit vor, dass die Solarzelle punktuell mit der Trägerstruktur verbunden wird, so dass außerhalb dieser stoffschlüssigen Verbindungen ein minimaler Luftspalt zwischen den Solarzellen und der Trägerstruktur realisiert werden kann.

Der grundlegende Gedanke beruht darauf, an den punktuellen Verbindungsstellen durch lokale Vertiefungen in der Trägerstruktur eine erhöhte Fugenbreite zu erzielen. Die erhöhte Fugenbreite ermöglicht den Ausgleich von thermo-mechanischen Verschiebungen durch Verformung des Kontaktmaterials der stoffschlüssigen Verbindung innerhalb der Vertiefung.

Vorzugsweise basiert die stoffschlüssige Verbindung zwischen den Solarzellen und der Trägerstruktur auf physikalischen und/oder chemischen Wechselwirkungen. Hierzu zählen insbesondere Klebeverbindungen. Die stoffschlüssige Verbindung besteht dabei aus einem Kontaktmaterial, das vorzugsweise aus einem temperaturbeständigen elastomeren Kunststoff besteht. Hierzu zählen bevorzugt Kautschuk-Materialien auf Basis von Silikon, Polyester, Polyurethan, Acrylat, Butyl, Acetat, Fluor.

Aufgrund der erfindungsgemäßen Lösung kann der Abstand zwischen der Trägerstruktur und den Solarzellen auf weniger als 50 µm, insbesondere auf 0,1 µm bis 10 µm reduziert werden.

Die Trägerstruktur weist dabei lokale Vertiefungen auf, die hinsichtlich ihrer Geometrie beliebig gewählt werden können. Die lokalen Vertiefungen weisen vorzugsweise eine Tiefe von 50 bis 500 µm auf.

Vorzugsweise sind die lokalen Vertiefungen gebohrt und/oder geprägt. Hierbei ist es auch möglich, dass eine Platte mit durchgängigen Bohrungen auf der Solarzelle und/oder der Trägerstruktur angeordnet wird.

Es ist bevorzugt, dass die Trägerstruktur aus Glas, einem Kunststoff oder aus einem Metall besteht. Unter diesen Materialien sind rückseitig besonders Aluminium-, Kupfer- oder Stahlbleche bevorzugt. Vorderseitig sind Glas oder transparente Kunststoffe wie Acrylat, Polycarbonat u.a. bevorzugt.

Es ist weiter bevorzugt, dass die Trägerstruktur und/oder die Solarzelle mit einer Schicht zur elektrischen Isolation, insbesondere aus einem Metalloxid oder einem organischen Material, z.B. einem Lack, belegt ist.

Eine erfindungsgemäße Variante sieht vor, dass die Trägerstruktur rückseitig von der Solarzelle angeordnet ist. Unter rückseitig ist im Rahmen der vorliegenden Erfindung die von der Solareinstrahlung abgewandte Seite der Solarzelle zu verstehen. In diesem Fall kann die Trägerstruktur eine solarthermische Absorberplatte darstellen, die bevorzugt aus einem metallischen Material besteht.

Eine weitere erfindungsgemäße Variante sieht vor, dass die Trägerstruktur frontseitig von der Solarzelle angeordnet ist. Unter frontseitig ist im Rahmen der vorliegenden Erfindung die der Solarstrahlung zugewandte Seite der Solarzelle zu verstehen. Bei dieser Variante besteht die Trägerstruktur vorzugsweise aus Glas oder einem Kunststoff, wobei diese im Wellenlängenbereich von 300 bis 1200 nm im Wesentlichen transparent sind.

Erfindungsgemäß wird es so ermöglicht, dass die flächige Ausdehnung der Bereiche der stoffschlüssigen Verbindung auf der Solarzelle einen Flächenanteil von 0,003 % bis 30 %, insbesondere ≤ 10 %, besonders bevorzug ≤ 2% ausmacht.

Durch den deutlich reduzierten Bedarf an Kontaktmaterial für die stoffschlüssige Verbindung, die sich auf 90 bis 99 % belaufen kann, werden erhebliche Kosten bei der Herstellung derartiger PV-Module eingespart. Ebenso wird es ermöglicht, dass besondere temperaturbeständige Kontaktmaterialien eingesetzt werden, um beispielsweise Solarzellen auf einer solarthermischen Absorberplatte zu fixieren, die im Stillstandbetrieb maximale Temperaturen von mindestens 150 °C erreichen kann. Gleichzeitig wird die Wärmeabgabe der Solarzelle an die Trägerstruktur verbessert, so dass der elektrische Ertrag und, in Kombination mit einer solarthermischen Absorberplatte, auch der Wärmeertrag steigt.

Erfindungsgemäß wird ebenso ein Verfahren zur Herstellung eines PV-Moduls, wie es zuvor beschrieben wurde, bereitgestellt, bei dem die stoffschlüssige Verbindung durch Aufbringen eines Kontaktmittels in flüssiger oder pastöser Form auf der mindestens einen Solarzelle und/oder der Trägerstruktur und anschließende thermische oder photochemische Aushärtung erfolgt.

Vorzugsweise wird das Kontaktmittel dabei gedruckt, gesprüht und/oder dosiert. Anhand der nachfolgenden Figuren soll der erfindungsgemäße Gegenstand näher erläutert werden, ohne diesen auf die hier gezeigten spezifischen Ausführungsformen einschränken zu wollen.
- Figur 1: zeigt ein PV-Modul gemäß Stand der Technik.
- Figur 2: zeigt ein erfindungsgemäßes PV-Modul im Grundzustand, d.h. ohne thermo-mechanische Verschiebung.
- Figur 3: zeigt ein erfindungsgemäßes PV-Modul bei Vorliegen thermo-mechanischer Verschiebung.
- Figur 4: zeigt eine weitere Variante des erfindungsgemäßen PV-Moduls.

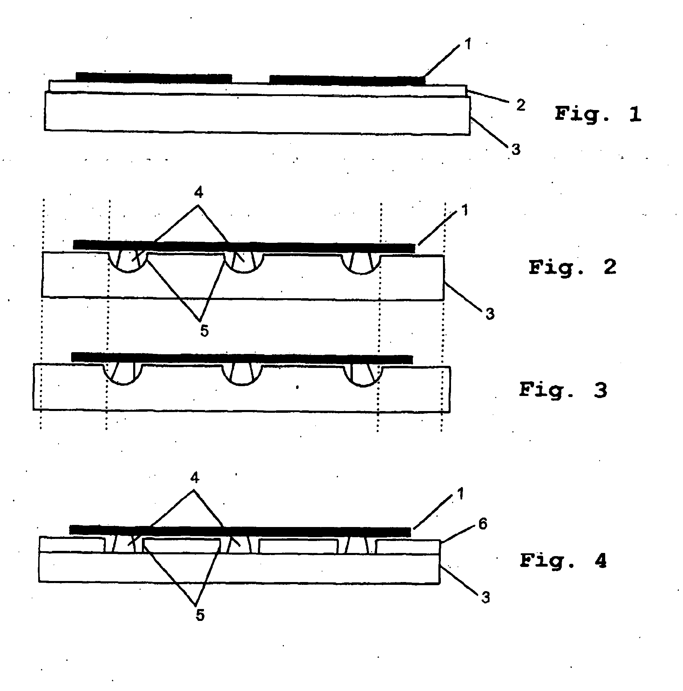

In Fig. 1 ist ein aus dem Stand der Technik bekanntes PV-Modul dargestellt. Hierbei werden die Solarzellen 1 mittels eines Kontaktmittels 2 auf der Trägerstruktur, hier in Form einer Trägerplatte 3, fixiert. Die Trägerplatte stabilisiert dabei die einzelnen Solarzellen und ihre gegenseitige Lage und schützt die Solarzellen vor kritischen mechanischen Belastungen oder auch vor Diffusion von korrosiven Stoffen wie Wasser oder Sauerstoff. Ebenso kann durch die Trägerplatte eine elektrische Isolation erreicht werden.

In Fig. 2 ist ein erfindungsgemäßes PV-Modul dargestellt, bei dem Solarzellen 1 punktuell mit einer Trägerstruktur 3 verbunden sind. Dabei weist die Trägerstruktur 3 Vertiefungen 5 auf, in denen über ein Kontaktmittel 4 eine stoffschlüssige Verbindung zu den Solarzellen hergestellt wird. Figur 2 zeigt dabei den Ausgangszustand des PV-Moduls ohne thermo-mechanische Verschiebung.

In Fig. 3 wird das gleiche erfindungsgemäße photovoltaische Modul bei erhöhter Temperatur gezeigt. Hierbei ist der thermische Ausdehnungskoeffizient der Trägerstruktur 3 größer als der thermische Ausdehnungskoeffizient der Solarzelle 1. Durch die Verformung des Kontaktmittels der stoffschlüssigen Verbindung können die thermo-mechanischen Verschiebungen ausgeglichen werden. Dies ist bei den beiden äußeren stoffschlüssigen Verbindungen zu erkennen.

In Fig. 4 ist eine weitere Variante des erfindungsgemäßen PV-Moduls dargestellt. Bei dieser Ausführungsform ist die Trägerstruktur 3 ein Absorberblech. Auf der Trägerstruktur 3 ist ein Blech 6 mit Bohrungen angeordnet, wobei in den Bohrungen die Kontaktmittel 4 der stoffschlüssigen Verbindung zur Solarzelle 1 angeordnet sind.

## Patentansprüche

1. Photovoltaisches (PV) Modul aus mindestens einer Solarzelle (1) und einer Trägerstruktur (3), wobei die Solarzelle (1) von der Trägerstruktur (3) durch einen Luftspalt beabstandet ist oder die Solarzelle bereichsweise auf der Trägerstruktur aufliegt und die Trägerstruktur mindestens eine lokal begrenzte Vertiefung (5) aufweist, in der eine elastische stoffschlüssige Verbindung (4) zwischen Solarzelle und Trägerstruktur angeordnet ist.

2. PV-Modul nach Anspruch 1,
**dadurch gekennzeichnet, dass** die stoffschlüssige Verbindung (4) auf physikalischen und/oder chemischen Wechselwirkungen basiert, insbesondere eine Klebeverbindung ist.

3. PV-Modul nach einem der vorhergehenden Ansprüche,
**dadurch gekennzeichnet, dass** die stoffschlüssige Verbindung (4) aus einem Elastomer, insbesondere Kautschuk-Materialien auf Basis von Silikon, Polyester, Polyurethan, Acrylat, Butyl, Acetat, Fluor besteht.

4. PV-Modul nach einem der vorhergehenden Ansprüche,
**dadurch gekennzeichnet, dass** der Abstand zwischen Trägerstruktur (3) und der Solarzelle (1) im Bereich von 0,1 µm bis 50 µm, insbesondere kleiner 10 µm, beträgt.

5. PV-Modul nach einem der vorhergehenden Ansprüche,
**dadurch gekennzeichnet, dass** die mindestens eine lokale Vertiefung (5) eine Tiefe von 50 bis 500 µm aufweist.

6. PV-Modul nach einem der vorhergehenden Ansprüche,
**dadurch gekennzeichnet, dass** die lokalen Vertiefungen (5) gebohrt und/oder geprägt sind.

7. PV-Modul nach einem der vorhergehenden Ansprüche,
**dadurch gekennzeichnet, dass** die Trägerstruktur (3) aus Glas, einem Kunststoff oder aus einem Metall besteht.

8. PV-Modul nach einem der vorhergehenden Ansprüche,
**dadurch gekennzeichnet, dass** die Trägerstruktur (3) und/oder die Solarzelle (1) mit einer Schicht zur elektrischen Isolation, insbesondere aus einem Metalloxid oder einem Lack, belegt ist.

9. PV-Modul nach einem der vorhergehenden Ansprüche,
**dadurch gekennzeichnet, dass** die Trägerstruktur (3) rückseitig von der Solarzelle (1) angeordnet ist und eine solarthermische Absorberplatte, insbesondere eine metallische Absorberplatte ist.

10. PV-Modul nach einem der vorhergehenden Ansprüche,
**dadurch gekennzeichnet, dass** die Trägerstruktur (3) frontseitig von der Solarzelle (1) angeordnet ist und insbesondere aus Glas oder einem Kunststoff, die im Wellenlängenbereich von 300 bis 1200 nm im Wesentlichen transparent sind, besteht.

11. PV-Modul nach einem der vorhergehenden Ansprüche,
**dadurch gekennzeichnet, dass** die flächige Ausdehnung der Bereiche der stoffschlüssigen Verbindung (4) auf der Solarzelle (1) einen Flächenanteil von 0,003% bis 30%, insbesondere von 0,003% bis 10% ausmacht.

12. Verfahren zur Herstellung eines PV-Moduls nach einem der vorhergehenden Ansprüche, bei dem die stoffschlüssige Verbindung (4) durch Aufbringen eines Kontaktmittels in flüssiger oder pastöser Form auf der mindestens einen Solarzelle (1) und/oder der Trägerstruktur (3) und anschließende thermische oder photochemische Aushärtung erfolgt.

13. Verfahren nach Anspruch 12,
**dadurch gekennzeichnet, dass** das Kontaktmittel gedruckt, gesprüht und/oder dosiert wird.

## Claims

1. Photovoltaic (PV) module made of at least one solar cell (1) and one carrier structure (3), the solar cell (1) being at a spacing from the carrier structure (3) by means of an air gap or the solar cell being situated in regions on the carrier structure and the carrier structure having at least one locally delimited depression (5) in which an elastic integral connection (4) is disposed between solar cell and carrier structure.

2. PV module according to claim 1,
**characterised in that** the integral connection (4) is based on physical and/or chemical interactions, in particular is a glued connection.

3. PV module according to one of the preceding claims,
**characterised in that** the integral connection (4) consists of an elastomer, in particular rubber materials based on silicone, polyester, polyurethane, acrylate, butyl, acetate, fluorine.

4. PV module according to one of the preceding claims,
**characterised in that** the spacing between carrier structure (3) and the solar cell (1) is in the range of 0.1 µm to 50 µm, in particular less than 10 µm.

5. PV module according to one of the preceding claims,
**characterised in that** the at least one local depression (5) has a depth of 50 to 500 µm.

6. PV module according to one of the preceding claims, **characterised in that** the local depressions (5) are bored and/or stamped.

7. PV module according to one of the preceding claims,
**characterised in that** the carrier structure (3) consists of glass, a plastic material or a metal.

8. PV module according to one of the preceding claims,
**characterised in that** the carrier structure (3) and/or the solar cell (1) is coated with a layer for electrical insulation, in particular made of a metal oxide or a paint.

9. PV module according to one of the preceding claims,
**characterised in that** the carrier structure (3) is disposed on the rear-side of the solar cell (1) and is a solar-thermal absorber plate, in particular a metallic absorber plate.

10. PV module according to one of the preceding claims,
**characterised in that** the carrier structure (3) is disposed on the front-side of the solar cell (1) and consists in particular of glass or a plastic material, which are essentially transparent in the wavelength range of 300 to 1,200 nm.

11. PV module according to one of the preceding claims,
**characterised in that** the planar extension of the regions of the integral connection (4) on the solar cell (1) constitutes a surface area proportion of 0.003% to 30%, in particular of 0.003% to 10%.

12. Method for production of a PV module according to one of the preceding claims, in which the integral connection (4) is effected by applying a contact means in liquid or paste form on the at least one solar cell (1) and/or on the carrier structure (3) and subsequent thermal or photochemical curing.

13. Method according to claim 12,
**characterised in that** the contact means is printed, sprayed and/or metered.

## Revendications

1. Module photovoltaïque (PV) constitué d'au moins une cellule solaire (1) et d'une structure portante (3), la cellule solaire (1) étant écartée de la structure portante (3) par une fente d'air, ou la cellule solaire s'appuyant par zones sur la structure portante, et la structure portante présente au moins une cavité limitée localement (5), dans laquelle une jonction élastique par liaison de matière (4) est disposée entre la cellule solaire et la structure portante.

2. Module PV selon la revendication 1, **caractérisé en ce que** la jonction (4) par liaison de matière se fonde sur des interactions physiques et/ou chimiques, et est en particulier une liaison collée.

3. Module PV selon l'une des revendications précédentes, **caractérisé en ce que** la jonction (4) par liaison de matière est constituée d'un élastomère, en particulier de matériaux de type caoutchouc à base de silicone, de polyester, de polyuréthanne, d'acrylate, de butyle, d'acétate, de fluor.

4. Module PV selon l'une des revendications précédentes, **caractérisé en ce que** la distance entre la structure portante (3) et la cellule solaire (1) est comprise dans la plage de 0,1 µm à 50 µm, et en particulier est inférieure à 10 µm.

5. Module PV selon l'une des revendications précédentes, **caractérisé en ce que** le ou les cavités locales (5) présentent une profondeur de 50 à 500 µm.

6. Module PV selon l'une des revendications précédentes, **caractérisé en ce que** les cavités locaux (5) sont percés et/ou estampés.

7. Module PV selon l'une des revendications précédentes, **caractérisé en ce que** la structure portante (3) est constituée de verre, d'un plastique ou d'un métal.

8. Module PV selon l'une des revendications précédentes, **caractérisé en ce que** la structure portante (3) et/ou la cellule solaire (1) sont pourvues d'une couche pour isolation électrique, en particulier constituée d'un oxyde métallique ou d'un vernis.

9. Module PV selon l'une des revendications précédentes, **caractérisé en ce que** la structure portante (3) est disposée sur l'envers de la cellule solaire (1), et est une plaque absorbante solaire thermique, en particulier une plaque absorbante métallique.

10. Module PV selon l'une des revendications précédentes, **caractérisé en ce que** la structure portante (3) est disposée le côté avant de la cellule solaire (1) et est en particulier constituée de verre ou d'un plastique, qui sont pour l'essentiel transparents dans la gamme de longueurs d'onde de 300 à 1200 nm.

11. Module PV selon l'une des revendications précédentes, **caractérisé en ce que** l'extension en surface des zones de jonction par liaison de matière (4) sur la cellule solaire (1) représente une proportion en aire de 0,003 % à 30 %, en particulier de 0,003 % à 10 %.

12. Procédé de fabrication d'un module PV selon l'une des revendications précédentes, dans lequel la jonction (4) par liaison de matière résulte de l'application d'un agent de contact sous forme liquide ou pâteuse sur la ou les cellules solaires (1) et/ou sur la structure portante (3), puis de son durcissement thermique ou photochimique.

13. Procédé selon la revendication 12, **caractérisé en ce que** l'agent de contact est imprimé, pulvérisé et/ou dosé.
